Europäisches Patentamt

European Patent Office

Office européen des brevets

(11) Numéro de publication: **0 350 363 B1**

(12) **FASCICULE DE BREVET EUROPEEN**

(45) Date de publication de fascicule du brevet: **14.09.94**  (51) Int. Cl.$^5$: **G01R 27/32**, G01R 27/22

(21) Numéro de dépôt: **89401773.0**

(22) Date de dépôt: **22.06.89**

(54) **Procédé et dispositif de détermination de l'impédance d'une décharge dans un réacteur à plasma.**

(30) Priorité: **24.06.88 FR 8808514**

(43) Date de publication de la demande:
**10.01.90 Bulletin 90/02**

(45) Mention de la délivrance du brevet:
**14.09.94 Bulletin 94/37**

(84) Etats contractants désignés:
**DE GB NL**

(56) Documents cités:
**EP-A- 0 064 413**

**THE BELL SYSTEM TECHNICAL JOURNAL, vol. 55, no. 6, juillet-août 1976, pages 691-721, American Telephone and Telegraph Co., US; J.G. EVANS et al.:"Automated network analyzers for the 0.9- to 12.4-GHz range"**

**J.W. Butterbaugh, L.D. Baston and H.H. Sawin: "Measurement and analysis of radio frequency glow dicharge electrical impedance and network power loss".**

(73) Titulaire: **COMMISSARIAT A L'ENERGIE ATO-MIOUE**
**31/33, rue de la Fédération**
**F-75015 Paris Cédex 15 (FR)**

(72) Inventeur: **Bouyer, Bernard**
**39 rue Marbeuf**
**F-38100 Grenoble (FR)**
Inventeur: **Andries, Bernard**
**9 rue Guy Môquet**
**F-38120 Echirolles (FR)**
Inventeur: **Ravel, Guillaume**
**6 rue Vaugelas**
**F-74000 Annecy (FR)**
Inventeur: **Peccoud, Louise**
**23 rue des Martyrs**
**F-38640 Claix (FR)**

(74) Mandataire: **Mongrédien, André et al**
**c/o BREVATOME**
**25, rue de Ponthieu**
**F-75008 Paris (FR)**

## Description

La présente invention concerne un procédé et un dispositif de détermination de l'impédance d'une décharge dans un réacteur à plasma associé à une boîte d'accord. Elle s'applique notamment à la régulation de l'impédance de la décharge ou du flux ionique dans ce réacteur.

La présente invention est utilisable avec tout réacteur de gravure ou de dépôt (par exemple de dépôt par pulvérisation) alimenté par un générateur d'ondes électromagnétiques de haute fréquence (plus simplement appelé "générateur de haute fréquence") par l'intermédiaire d'une boîte d'accord permettant d'adapter l'impédance de sortie du générateur à l'impédance d'entrée du réacteur. L'invention s'applique par exemple aux réacteurs de type GIR (Gravure Ionique Réactive), aux réacteurs utilisant un magnétron, à ceux qui utilisent une triode.

Par "haute fréquence", on entend une fréquence inférieure à 10 GHz (radiofréquence, hyperfréquence, ...).

L'impédance d'une décharge dans un réacteur de gravure ou de dépôt est une caractéristique fondamentale de ce réacteur. La connaissance de cette impédance permet d'accéder à des caractéristiques essentielles du réacteur en fonctionnement telles que le flux ionique (ou densité de courant ionique) et l'énergie des ions. En particulier, ces caractéristiques sont importantes lorsqu'on effectue des gravures anisotropes qui jouent un rôle essentiel dans la fabrication de circuits intégrés à très forte intégration.

L'impédance de la décharge est un nombre complexe Z qui est égal au rapport de la tension électrique sinusoïdale V existant entre les bornes du réacteur en fonctionnement, à l'intensité également sinusoïdale I du courant électrique qui traverse alors ce réacteur.

On connaît déjà trois techniques de mesure de l'impédance d'une décharge dans un réacteur à plasma.

Une première technique connue consiste à mesurer la tension V, l'intensité I et le déphasage entre ceux-ci tout en essayant d'éliminer les nombreuses composantes harmoniques que présentent V et I. Cette première technique connue nécessite un montage approprié qui est difficilement utilisable avec les réacteurs à plasma industriels.

Une deuxième technique connue consiste à mesurer ou à calculer l'impédance de sortie de la boîte d'accord associée au réacteur.

Cette deuxième technique est décrite dans l'article de A.J. Van ROOSMALEN intitulé "Plasma parameter estimation from RF impedance" et publié dans Appl. Phys. Lett. 42(5), 1er mars 1983, p. 416 à 418, ainsi que dans l'article de N. NORSTROM intitulé "Experimental and design information for calculating impedance matching networks for use in RF sputtering and plasma chemistry" et publié dans Pergamon Press Vacuum, vol. 29, numéro 10, 1979, p. 341 à 350.

Cependant, cette deuxième technique connue présente des inconvénients : avec cette technique, on ne mesure pas l'impédance de la décharge seule mais on mesure également l'impédance de la liaison entre le réacteur et la boîte d'accord ainsi que l'impédance à vide du réacteur d'où la nécessité de faire une analyse fine de ces impédances et de les introduire dans des formules de correction ; en outre, la boîte d'accord est un adaptateur d'impédance qui n'est pas parfait: une part de l'énergie incidente y est perdue par effet Joule ou par rayonnement électromagnétique, ce qui empêche en fin de compte l'évaluation des impédances parasites que constituent l'impédance de la liaison entre le réacteur et la boîte d'accord et l'impédance à vide du réacteur.

Une troisième technique connue est décrite dans l'article de B.ANDRIES et al., intitulé "Méthode de caractérisation électrique de machines de gravure plasma à couplage capacitif" et publié dans les comptes rendus des travaux du CIPG 87 par la Société Française du Vide, Antibes, 1-5 juin 1987, pages 106 à 109. Cette troisième technique connue consiste à calculer l'impédance de la décharge à partir de mesures de facteurs de dispersion (connus sous le nom de "paramètres S") de la boîte d'accord reliée au réacteur éteint et préalablement accordé. Le réacteur est accordé lorsque son impédance d'entrée est rendue égale à l'impédance de la ligne d'alimentation du réacteur, cette impédance étant généralement égale à 50 ohms, de façon à annuler la puissance réfléchie vers le générateur. Ces mesures sont faites à l'aide d'un analyseur vectoriel, à la fréquence du générateur qui est généralement égale à 13,56 MHz.

Cette troisième technique permet de calculer effectivement l'impédance Z de la décharge, en intégrant l'effet de toutes les impédances parasites, et ne nécessite pas de supposer la boîte d'accord parfaite c'est-à-dire l'absence de pertes d'énergie dans celle-ci. Cependant, cette troisième technique connue présente des inconvénients : elle ne permet pas de mesurer l'impédance de la décharge en temps réel, c'est-à-dire de façon continue, lorsque le réacteur fonctionne (par exemple au cours d'une gravure). De plus, les analyseurs vectoriels sont des appareils coûteux et il est difficilement envisageable de laisser en permanence de tels analyseurs vectoriels sur des réacteurs industriels.

La présente invention a pour but de remédier aux inconvénients précédents en proposant un procédé et un dispositif de détermination de l'impédance d'une décharge dans un réacteur à plasma, qui sont utilisables avec un réacteur industriel, qui permettent de déterminer l'impédance de la décharge en intégrant l'effet de toutes les impédances parasites, et sans supposer l'absence de pertes d'énergie dans la boîte d'accord, qui ne nécessitent pas l'immobilisation d'un analyseur vectoriel auprès du réacteur et, surtout, qui permettent de déterminer l'impédance Z de la décharge en temps réel, sans perturber le plasma.

Or, il peut être utile de connaître en permanence l'impédance de la décharge : dans le cas de la gravure d'un circuit intégré par exemple, cette impédance varie en fin de gravure et sa connaissance peut permettre de détecter la fin de l'attaque du circuit intégré; on sait par ailleurs que les réacteurs se polluent au cours du temps et que cette pollution se traduit par une variation d'impédance, d'où l'intérêt de connaître l'impédance de la décharge pour détecter cette pollution; enfin, notamment dans le cas de la gravure d'une plaquette semi-conductrice, on sait que l'impédance de la décharge peut être reliée mathématiquement au flux ionique et à l'énergie des ions dans le réacteur et la connaissance en permanence de l'impédance de la décharge permet de contrôler une éventuelle dérive au cours du temps des deux paramètres que constituent ce flux et cette énergie, paramètres qui sont essentiels pour la gravure.

De façon précise, la présente invention a tout d'abord pour objet un procédé de détermination de l'impédance d'une décharge dans un réacteur à plasma de haute fréquence associé à une boîte d'accord comportant des capacités variables, caractérisé en ce qu'il comprend les étapes suivantes :

- on établit préalablement et expérimentalement une correspondance entre, d'une part, des états respectifs des capacités variables, qui sont déterminés réacteur éteint, hors fonctionnement, pour avoir une puissance réfléchie nulle en direction du générateur et, d'autre part, l'impédance de la décharge mesurée pour lesdits états des capacités, réacteur éteint,
- on détermine l'impédance de la décharge du réacteur allumé en fonctionnement, à partir des états pris par les capacités variables pour avoir une puissance réfléchie nulle, et de la correspondance préalablement établie.

On peut déterminer en outre le flux ionique relatif à la décharge dans le réacteur en fonction de la tension haute fréquence appliquée entre les bornes du réacteur, des états respectifs des capacitiés variables et à l'aide d'une correspondance préalablement établie entre d'une part les états susceptibles d'être pris par les capacités variables et d'autre part l'impédance de la décharge.

De façon plus précise, on détermine le flux ionique à partir de l'impédance de la décharge en reliant cette dernière, par un modèle de décharge approprié, à la gaine et au plasma de la décharge. La connaissance de l'impédance de la gaine de la décharge (et de la tension appliquée entre les bornes du réacteur) permet alors de déterminer le flux ionique.

Des modèles de décharge sont donnés dans l'article de THOMPSON et al. intitulé "Ion bombardment energy distribution in radio-frequency glow-discharge systems" et publié dans Appl. Phys. 59(6), 15 mars 1986, p. 1890 à 1903 et dans l'article de R.H. BRUCE intitulé "Ion response to plasma excitation frequency" et publié dans Appl. Phys. 52(12), décembre 1981, p. 7064 à 7066.

La présente invention a également pour objet un dispositif de détermination de l'impédance d'une décharge dans un réacteur à plasma de haute fréquence associé à une boîte d'accord comportant des capacités variables, caractérisé en ce qu'il comprend :

- des capteurs aptes à fournir des signaux représentatifs des états respectifs de ces capacités variables, et
- des moyens électroniques de traitement prévus pour déterminer l'impédance de la décharge au moyen de ces signaux et à l'aide d'une correspondance préalablement établie entre d'une part les états susceptibles d'être pris par les capacités variables et d'autre part l'impédance de la décharge, cette correspondance étant mémorisée dans les moyens électroniques de traitement.

Les moyens électroniques de traitement peuvent être prévus pour déterminer le flux ionique relatif à la décharge dans le réacteur au moyen de la tension haute fréquence appliquée entre les bornes du réacteur, des signaux fournis par les capteurs et à l'aide d'une correspondance préalablement établie entre d'une part les états susceptibles d'être pris par les capacités variables et d'autre part l'impédance de la décharge, cette correspondance étant mémorisée dans les moyens électroniques de traitement.

Des aspects essentiels de la présente invention sont donc :

- la reconnaissance de l'existence d'une correspondance bijective entre les états - encore appelés "positions" par la suite - des capacités variables de la boîte d'accord et l'impédance de la décharge (et éventuellement le flux ionique relatif à cette décharge pour une tension haute fréquence donnée, appliquée entre les bornes du réacteur), en supposant que l'impédance du réacteur éteint (c'est-à-dire ne fonctionnant pas) soit constante quel que soit le réglage des capacités variables de la boîte d'accord associée, et

- l'utilisation des états des capacités variables de la boîte d'accord à un instant donné pour déterminer, à cet instant, la valeur de l'impédance de la décharge et éventuellement le flux ionique, au moyen de ladite correspondance préalablement établie.

La présente invention concerne enfin un système de régulation de l'impédance de la décharge ou du flux ionique dans un réacteur à plasma de haute fréquence alimenté par un générateur de haute fréquence par l'intermédiaire d'une boîte d'acord associée à des moyens d'accord automatique, la boîte d'accord comportant des capacités variables et étant prévue pour adapter l'impédance de sortie du générateur à l'impédance d'entrée du réacteur, les moyens d'accord automatique étant prévus pour ajuster les états des capacités variables de la boîte d'accord par l'intermédiaire de moyens de modification de ces états, de façon à annuler la puissance réfléchie vers le générateur, système caractérisé en ce qu'il comprend un dispositif conforme à l'invention dans lequel les moyens électroniques de traitement sont prévus pour déterminer l'impédance de la décharge ou le flux ionique, et en ce que les moyens électroniques de traitement que comporte le dispositif sont en outre prévus pour commander la puissance du générateur de telle manière que l'impédance de la décharge ou le flux ionique qu'ils déterminent soit maintenu égal à une valeur de consigne.

Les moyens de modification du dispositif peuvent être des moteurs et les capteurs, des capteurs de type potentiométrique respectivement montés sur les arbres de ces moteurs.

La présente invention sera mieux comprise à la lecture de la description qui suit, d'exemples de réalisation donnés à titre purement indicatif et nullement limitatif, en référence aux dessins annexés sur lesquels :

- la figure 1 est une vue schématique d'un système connu de commande de réacteur à plasma,
- la figure 2 est un schéma électrique possible pour la boîte d'accord associée à ce réacteur,
- la figure 3 est un montage permettant l'établissement de la correspondance mentionnée plus haut entre les états des capacités variables de la boîte d'accord et l'impédance de la décharge dans le réacteur et éventuellement le flux ionique dans ce réacteur,
- la figure 4 illustre schématiquement un montage réalisé sur le réacteur pour l'établissement de cette correspondance,
- la figure 5 est un schéma illustrant le fait que la boîte d'accord peut être considérée comme un quadripôle, que le réacteur peut être considéré comme un dipôle et que l'ensemble réacteur plus boîte d'accord peut être considéré comme un quadripôle,
- la figure 6 est une vue schématique d'un mode de réalisation particulier d'un système de commande d'un réacteur à plasma, conformément à la présente invention, et
- la figure 7 est un schéma illustrant un capteur particulier, apte à fournir un signal représentatif de l'état d'une capacité variable de la boîte d'accord.

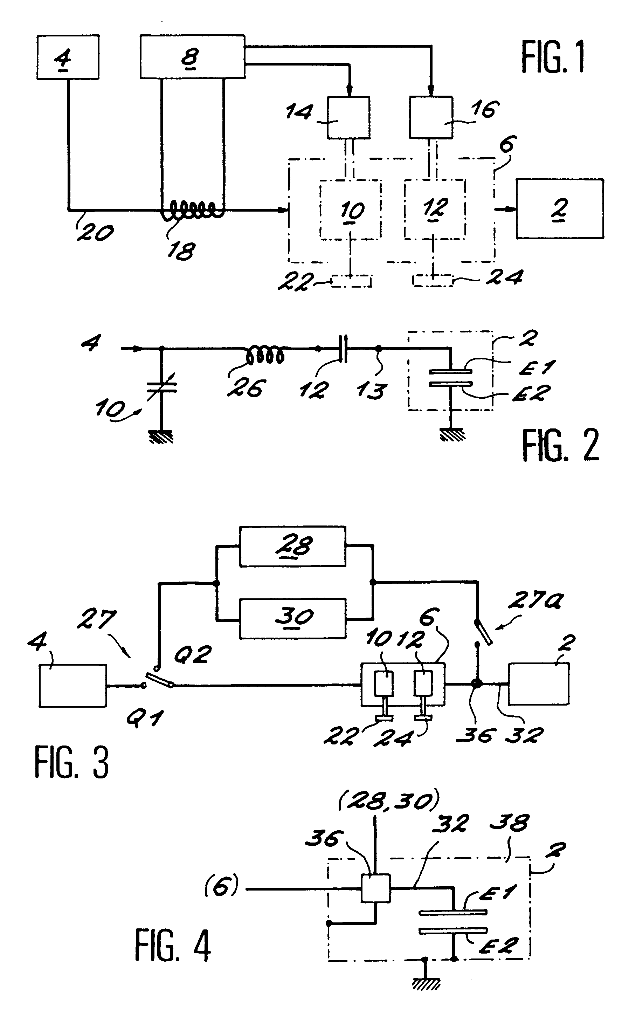

Sur la figure 1, on a représenté schématiquement un système connu de commande d'un réacteur à plasma 2 de haute fréquence qui est par exemple destiné à la gravure de plaquettes semi-conductrices. Ce réacteur 2 est alimenté par un générateur de haute fréquence 4 (il s'agit par exemple d'une radiofréquence), par l'intermédiaire d'une boîte d'accord 6. Le système comprend également des moyens 8 d'accord automatique qui sont prévus pour maintenir en permanence l'accord optimal entre le générateur et le réacteur.

La boîte d'accord 6 comporte des capacités variables 10 et 12 dont les états -ou positions- sont respectivement imposés par des moteurs 14 et 16 commandés par les moyens d'accord automatique 8. A cet effet, ces moyens d'accord automatique 8 utilisent un couplage inductif 18 établi entre eux et la ligne 20 -généralement un câble coaxial- reliant le générateur 4 à la boîte d'accord 6.

Sur la figure 1, on aperçoit également des boutons 22 et 24 permettant de régler manuellement respectivement les positions des capacités variables 10 et 12 de la boîte d'accord 6 pour réaliser l'accord optimal (en l'absence des moyens d'accord automatiques 8 et par exemple pour des essais préalables du réacteur 2). Chaque capacité comporte une partie mobile et une partie fixe non représentées et le bouton correspondant est rigidement solidaire de la partie mobile.

La figure 2 représente un schéma électrique possible pour la boîte d'accord 6. Celle-ci comprend la capacité variable 10 encore appelée "capacité d'accord" et la capacité variable 12 encore appelée "capacité de charge". Une borne de la capacité 10 est mise à la masse tandis que son autre borne est reliée à la ligne issue du générateur 4 (ou plus exactement à l'âme du câble coaxial 20 dont la tresse est mise à la masse) ainsi qu'à une borne d'une inductance 26 dont l'autre borne est reliée à une borne de la capacité 12. L'autre borne 13 de la capacité 12 est reliée à l'une E1 des deux électrodes du réacteur 2, l'autre électrode E2 de ce réacteur étant mise à la masse.

L'électrode E1 est celle par laquelle on applique la tension haute fréquence pour faire fonctionner le réacteur et sert à créer la décharge dans celui-ci tandis que l'électrode E2, mise à la masse, sert de potentiel de référence.

Comme on l'a déjà indiqué plus haut, on a mis en évidence l'existence d'une correspondance bijective entre (a) les positions respectives p1 et p2 des capacités 10 et 12 par rapport à une position de référence et l'impédance Z de la décharge dans le réacteur 2 en fonctionnement et aussi (b) entre ces positions et le flux ionique J relatif à cette décharge (pour une tension haute fréquence donnée, appliquée entre les bornes du réacteur). Ces quantités Z et J sont ainsi des fonctions du couple (p1, p2) pour une composition de gaz générateur de plasma et une pression de ce gaz fixées.

La figure 3 illustre schématiquement un montage permettant l'établissement de cette correspondance. Dans ce montage le générateur 4 peut être connecté au réacteur 2 ou au contraire déconnecté de celui-ci grâce à un interrupteur 27 par exemple (voir plus loin), par l'intermédiaire duquel le générateur 4 est relié à la boîte d'accord 6 munie des boutons 22 et 24 de réglage des capacités variables que cette boîte d'accord comporte. Le réglage des boutons 22 et 24 peut être fait aussi bien de façon manuelle que de façon automatique.

En revanche, les moyens d'accord automatique 8 ainsi que le couplage inductif 18 qui leur est associé sont supprimés.

Un analyseur vectoriel 28 et un wattmètre directif 30 sont montés (seulement pendant l'établissement de la correspondance) en parallèle entre l'entrée et la sortie de la boîte d'accord 6, par l'intermédiaire de l'interrupteur 27 et d'un autre interrupteur 27a - voir plus loin. L'analyseur vectoriel 28 et le wattmètre 30 permettent la détermination de Z.

L'établissement de la correspondance mentionnée plus haut, pour laquelle on utilise le montage représenté sur la figure 3, suppose, d'une part, comme on l'a déjà indiqué, que l'impédance du réacteur éteint soit constante quel que soit le réglage de la boîte d'accord et, d'autre part, que l'on puisse définir correctement les plans de référence du quadripôle que constitue la boîte d'accord (voir plus bas). On entend, par "plans de références", les lieux de connexion de l'analyseur vectoriel et du wattmètre de part et d'autre de la boîte d'accord. Il faut en particulier que le plan de référence de sortie, c'est-à-dire le lieu de la connexion de l'analyseur et du wattmètre à la sortie de la boîte d'accord, soit le plus proche possible des bornes entre lesquelles se produit la décharge afin de prendre en compte le plus possible les impédances parasites mentionnées plus haut à propos de la deuxième technique connue (voir p. 2 et 3).

A cet effet, on utilise un fil métallique 32 (figure 4) qui est relié d'un côté à l'électrode E1 du réacteur et de l'autre côté, à une borne d'une prise 36 dont les autres bornes sont électriquement reliées à la boîte d'accord et à l'ensemble analyseur-wattmètre et dont le blindage est relié au bâti 38 du réacteur, ce bâti étant mis à la masse. La longueur du fil métallique 32 ne dépasse pas, de façon avantageuse, 30 centimètres.

Sur la figure 3, on voit que l'interrupteur 27 est à deux positions qui s'excluent mutuellement :
- une position Q1 dans laquelle le générateur 4 est connecté à la boîte d'accord, et
- une position Q2 dans laquelle l'entrée de la boîte d'accord est connectée à la borne commune à l'analyseur 28 et au wattmètre 30 du côté de cette entrée.

On voit également que l'interrupteur 27a est prévu pour connecter à la borne appropriée de la prise 36, ou au contraire déconnecter de cette borne, la borne commune à l'analyseur 28 et au wattmètre 30 du côté de la sortie de la boîte d'accord.

Ainsi, pour l'établissement de la correspondance, l'interrupteur 27 est dans la position Q2 (le générateur est débranché) et l'interrupteur 27a est fermé (les interrupteurs relient l'analyseur et le wattmètre à la boîte d'accord). Au contraire, lors du fonctionnement du réacteur (aprés établissement de la correspondance), l'interrupteur 27 est dans la position Q1 (le générateur est branché à la boîte d'accord) et l'interrupteur 27a est ouvert (l'analyseur et le wattmètre ne sont pas reliés à la boîte d'accord et peuvent être enlevés).

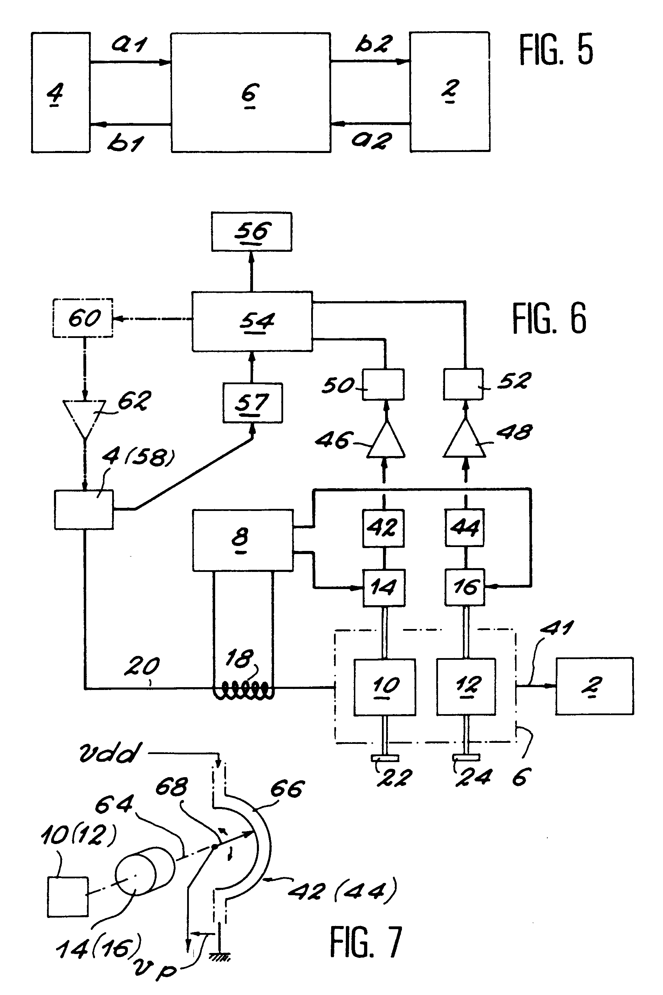

La boîte d'accord 6 peut être considérée comme un quadripôle (figure 5) et le réacteur 2 comme un dipôle, l'ensemble formant un quadripôle. Lorsque le système constitué par le réacteur 2, le générateur 4 et la boîte d'accord 6 est en fonctionnement, la boîte d'accord 6 reçoit du générateur 4 une onde incidente d'amplitude a1 et réfléchit en direction de ce générateur une onde d'amplitude b1. En outre, la boîte d'accord 6 envoie en direction du réacteur une onde incidente d'amplitude b2 et reçoit de ce réacteur une onde réfléchie d'amplitude a2.

Le quadripôle que constitue la boîte d'accord 6 et le réacteur 2 est caractérisé par quatre coefficients complexes S11, S12, S21 et S22 qui sont appelés "facteurs de dispersion" et dont l'ensemble constitue ce que l'on appelle la matrice de dispersion du quadripôle (voir l'article de B. ANDRIES et al. mentionné plus haut).

Le quadripôle étant constitué uniquement d'éléments passifs, les quantités S12 et S21 sont égales.

La correspondance est établie de la façon suivante : le générateur étant débranché et l'ensemble analyseur-wattmètre branché (interrupteur 27 en position Q2 et interrupteur 27a fermé) et le réacteur étant donc éteint, la position p1 étant susceptible de varier dans un intervalle (A1, B1) et la position p2 étant susceptible de varier dans un intervalle (A2, B2), on choisit des valeurs de p1 et p2 dans leurs intervalles respectifs et l'on règle en conséquence les capacités variables 10 et 12 respectivement au moyen des boutons 22 et 24.

On détermine alors les quantités complexes S11, S12 et S22 au moyen de l'analyseur vectoriel et du wattmètre directif. Pour cela, de façon connue, l'analyseur vectoriel envoie une onde de référence dans la boîte d'accord et sur une charge caractéristique d'impédance Zc et l'ensemble analyseur vectoriel et wattmètre mesure ensuite le déphasage et l'atténuation correspondant à l'onde réfléchie vers l'analyseur. L'impédance Zc est équivalente à l'impédance caractéristique de la ligne qui relie le réacteur à la boîte d'accord, cette impédance étant généralement de 50 ohms.

Par ailleurs, on note r la quantité a2/b2 qui constitue le facteur de réflexion (ou coefficient de réflexion) du plasma (le réacteur étant supposé en fonctionnement). L'impédance Z de la décharge dont la partie réelle (impédance du plasma) et la partie imaginaire (impédance de la gaine de la décharge) sont respectivement notées R et -X, est telle que :

$$Z = R{-}jX = Zc\,(1+r).(1{-}r)^{-1} \text{ avec } j^2 = -1.$$

Or, on peut écrire, lorsque le réacteur fonctionne, le système d'équations suivant :

$$b1 = S11.a1 + S12.a2$$
$$b2 = S21.a1 + S22.a2$$

En tenant compte du fait que les quantités S12 et S21 sont égales, que a2 est égal à r.b2 et que b1 est nul lorsque le réacteur est accordé, ce système devient :

$$0 = S11.a1 + S12.r.b2$$
$$b2 = S12.a1 + S22.r.b2$$

Ce système peut encore s'écrire :

$$s11.a1 + S12.r.b2 = 0$$
$$S12.a1 + ((S22.r){-}1)b2 = 0 \qquad (1)$$

Les quantités a1 et b2 de ce dernier système n'étant pas nulles, le déterminant de ce dernier système est nul. Il en résulte :

$$S11.S22.r - S11 = (S12)^2 r$$

On en déduit la valeur de r :

$$r = S11.(S11.S22 - (S12)^2)^{-1}$$

La mesure des quantités complexes S11, S12 et S22 permet ainsi de déterminer la quantité complexe r et, de ce fait, l'impédance Z de la décharge, et donc les parties réelle et imaginaire de Z. De plus, la détermination de la puissance utile Wu permet de calculer la tension haute fréquence $V_{HF}$ entre les bornes du réacteur par la formule :

$$V_{HF} = (2Wu\,(R^2 + X^2)R^{-1})^{1/2}$$

On peut déterminer la puissance utile Wu par calcul, à partir de la mesure de la puissance W fournie par le générateur haute fréquence (mesure faite sur le générateur supposé, dans ce cas, en fonctionnement) et du calcul du rendement n = Wu/W.

On en déduit : Wu = n.W.

Le calcul du rendement n est donné ci-après :

$$\text{On a : } Wu = |b2|^2 - |a2|^2$$
$$= |b2|^2(1-|r|^2)$$

De plus : $W = |a1|^2 - |b1|^2$ .

Donc, lorsque le réacteur est accordé, W est égal à $|a1|^2$ et le rendement n est donc égal à :

$$n = Wu/W = |b2/a1|^2.(1-|r|^2).$$

Or l'équation (1) donnée plus haut permet d'écrire :

$$b2/a1 = S12/(1-rS22).$$

Il en résulte :

$$n = |S12|^2.(1-|r|^2)/|1-r\,S22|^2.$$

Le rendement n est donc calculable à partir des quantités S11, S12 et S22.

La tension $V_{HF}$ (pour une puissance W donnée) peut être également déterminée par une mesure effectuée directement entre les bornes du réacteur (supposé, dans ce cas, en fonctionnement).

On peut alors déterminer le flux ionique J en utilisant la loi de CHILD LANGMUIR. Le flux ionique est alors égal à :

$$J = k1\,(V_{HF})^{3/2}X^{-2}$$

La quantité k1 est une constante qui dépend des conditions expérimentales (composition du gaz et surface de l'électrode reliée au générateur) et qui vaut 10,66 pour du $SF_6$ et pour une surface d'électrode reliée au générateur de 226 $cm^2$ (J, $V_{HF}$

et X étant respectivement exprimés en A.m$^{-2}$, volts et ohms).

En utilisant, si l'on préfère, la loi des décharges collisionnelles, le flux ionique J est tel que :

$$J = k2 (V_{HF})^{3/2} X^{-2,5}$$

La quantité k2 est encore une constante qui dépend des conditions expérimentales et qui vaut 2,67 pour du $SF_6$ à une pression de 20 millitorrs (environ 2,66 Pa).

On a ainsi Z et J pour un couple (p1, p2). On comprend donc que l'on puisse déterminer Z et J pour tout couple (p1, p2), p1 étant choisi dans l'intervalle (A1, B1) et p2 dans l'intervalle (A2, B2).

On obtient ainsi la correspondance cherchée qui, à un couple (p1, p2) donné, associe une impédance de décharge Z déterminée (et un flux ionique J déterminé pour une puissance W donnée). Cette correspondance peut par exemple être traduite sous la forme d'un tableau.

Dans ce tableau, chacun des intervalles (A1, B1) et (A2, B2) est découpé en sous-intervalles de sorte que l'on a deux séries de valeurs A1, ..., $p1_i$, $p1_{i+1}$, ..., B1 et A2, ..., $p2_l$, $p2_{l+1}$, ..., B2, i et l étant des nombres entiers. Dans chaque série, les valeurs sont séparées les unes des autres par un pas constant et ce pas est suffisamment faible pour permettre des calculs précis. Le tableau est à double entrée et donne R et X (et donc Z) pour tout couple ($p1_i$, $p2_l$). En variante, on peut former un tableau qui donne, pour tout couple ($p1_i$, $p2_l$), les paramètres S11, S12 et S22, paramètres qui, pour Zc donné, permettent de calculer Z ainsi que J (pour W donné), comme on l'a vu plus haut.

Un tel tableau est utilisable pour la connaissance, en temps réel, de l'impédance Z du plasma et/ou du flux ionique J (pour connaître J, on utilise de façon avantageuse le tableau donné ci-dessus en variante ou un tableau équivalent), et éventuellement pour la régulation de cette impédance ou du flux ionique dans un réacteur à plasma, comme on va le voir dans ce qui suit.

La connaissance de Z et/ou de J en permanence (ou plus simplement périodiquement) permet de suivre l'évolution de ce ou ces paramètres importants du plasma pendant un processus de gravure ou de dépôt. Cette connaissance permet aussi de mémoriser les positions respectives des capacités variables de la boîte d'accord correspondant à chaque procédé de gravure ou de dépôt en vue d'utiliser ces positions ultérieurement.

Le maintien d'un flux ionique J constant dans le réacteur est intéressant dans le cas de la gravure de plaquettes semi-conductrices par exemple, car l'opération de gravure est alors reproductible (mêmes résultats d'une plaquette à l'autre).

Sur la figure 6, on a représenté schématiquement un système de commande du réacteur à plasma 2, ce système permettant en outre de connaître à la demande ou à tout instant ou périodiquement, par exemple toutes les secondes, l'impédance et/ou le flux ionique dans ce réacteur à plasma en fonctionnement, conformément à la présente invention.

Le système représenté sur la figure 6 comprend notamment tout les éléments du système représenté sur la figure 2, agencés de la même façon, le générateur 4 étant à puissance réglable.

La ligne 41 reliant la boîte d'accord au réacteur peut être réalisée au moyen d'un câble coaxial dont l'âme relie ladite borne 13 de la capacité 12 à l'électrode E1 du réacteur et dont la tresse est mise à la masse, ou au moyen d'un ruban de clinquant reliant la borne 13 à l'électrode E1.

En outre, le système comprend des capteurs 42 et 44 qui sont respectivement associés aux capacités variables 10 et 12 de la boîte d'accord comme on le verra par la suite et qui sont prévus pour fournir des signaux électriques représentatifs des positions respectives de ces capacités 10 et 12. Ces signaux sont respectivement amplifiés par des amplificateurs appropriés 46 et 48 et numérisés par des convertisseurs analogiques-numériques 50 et 52.

Le système comprend aussi des moyens électroniques de traitement 54 dans lesquels est mémorisé le tableau donnant R et X (ou dans lesquels sont mémorisés Zc et le tableau donné plus haut en variante) en fonction de p1 et p2, qui reçoivent en entrée les signaux numérisés issus des convertisseurs analogiques-numériques 50 et 52 et qui sont prévus pour déterminer l'impédance Z de la décharge en fonction de ces signaux représentatifs des positions des capacités de la boîte d'accord.

Les moyens électroniques de traitement 54 sont reliés à des moyens de visualisation 56 permettant d'afficher les valeurs de l'impédance de la décharge ainsi déterminées.

On peut, en variante, fournir aux moyens électroniques de traitement 54 la valeur de la puissance W fournie par le générateur 4, ce qui permet à ces moyens électroniques de traitement de déterminer (à la demande ou à tout instant ou périodiquement) le flux ionique J dans le réacteur et d'afficher les valeurs ainsi déterminées sur les moyens de visualisation 56. Dans ce cas, il convient de préférence de mémoriser dans les moyens électroniques de traitement le tableau donné plus haut en variante (ou un tableau équivalent) et, bien entendu, le paramètre k1 ou k2 mentionné plus haut. Par ailleurs, la valeur de la puissance W peut être fournie aux moyens 54 de la façon suivante: le générateur comportant une sortie donnant cette valeur de W sous forme analogique, on relie cette sortie à une entrée appropriée des moyens 54, par l'intermédiaire d'un convertisseur analogique-numérique 57.

Si on le souhaite, les moyens électroniques de traitement peuvent déterminer Z et J et les afficher sur les moyens de visualisation 56.

Dans les moyens électroniques de traitement, étant donné deux valeurs p1 et p2 fournies par les capteurs, la détermination de R et X (ou de S11, S12, S22) qui correspondent à ces valeurs peut être faite, par exemple par une technique d'interpolation linéaire à deux variables.

Le système schématiquement représenté sur la figure 6 peut être complété pour permettre par exemple de maintenir J à une valeur constante Jc. A cet effet, le générateur 4 est remplacé par un générateur 58 de haute fréquence qui peut être commandé par une tension analogique. Dans ce système modifié, les moyens électroniques de traitement 54 sont prévus pour déterminer le flux ionique J en fonction des signaux fournis par les capteurs 42 et 44, pour comparer J à une valeur de consigne mémorisée Jc et, si J est différent de Jc, fournir un signal numérique d'erreur destiné à modifier la puissance du générateur 58. A cet effet, le système comprend en outre un convertisseur numérique-analogique 60 qui reçoit le signal d'erreur pour le convertir en un signal de tension analogique qui est amplifié par des moyens d'amplification appropriés 62 dont la sortie commande le générateur 58.

Lorsque J est inférieur à Jc, le signal d'erreur engendré dans les moyens électroniques de traitement est prévu pour augmenter la puissance du générateur 58 et, inversement, lorsque J est supérieur à Jc, le signal d'erreur engendré dans les moyens électroniques de traitement est prévu pour diminuer la puissance du générateur 58.

Bien entendu, on peut de même maintenir Z à une valeur de consigne ZC par ce système, en adaptant convenablement les moyens électroniques de traitement 54 pour que ceux-ci déterminent Z à partir des signaux fournis par les capteurs 42 et 44, comparent Z à la valeur ZC mémorisée et fournissent, si Z est différent de ZC, un signal d'erreur destiné à modifier en conséquence la puissance du générateur 58.

Sur la figure 7, on a représenté schématiquement un mode de réalisation particulier des capteurs 42 et 44. Dans ce mode de réalisation particulier, chaque capteur 42 ou 44 est de type potentiométrique : il consiste en un potentiomètre qui est monté sur l'arbre 64 du moteur correspondant. Le capteur comprend une piste électriquement résistante 66 qui est fixe par rapport au moteur et disposée en regard d'une extrémité de l'arbre 64 de celui-ci, dans un plan perpendiculaire à cet arbre 64. Cette extrémité est rigidement solidaire d'un curseur 68 électriquement conducteur qui est prévu pour frotter, par une extrémité, sur la piste résistante 66. Une extrémité de la piste 66 est alimentée par une tension électrique constante $v_{dd}$, l'autre extrémité de la piste 66 étant mise à la masse. L'autre extrémité du curseur 68 fournit ainsi une tension électrique $v_p$ qui est égale à $v_{dd}$ multiplié par un coefficient proportionnel à la position de la capacité variable associée au moteur dont l'axe 64 est rigidement lié à la partie mobile (non représentée) de la capacité variable et tourne toujours du même angle que cette partie mobile.

Pour l'établissement du tableau à mémoriser, on peut utiliser les capteurs 42 et 44, associés aux amplificateurs 46 et 48 et aux convertisseurs 50 et 52, pour rentrer dans la mémoire (non représentée) des moyens électroniques de traitement 54 les divers couples ($p1_i$ , $p2_i$) sélectionnés.

Bien entendu, d'autres capteurs de position sont utilisables dans la présente invention : au lieu de capteurs potentiométriques, on peut utiliser des dynamos tachymétriques, des capteurs magnétiques, des capteurs par effet HALL, des capteurs optiques, des capteurs mécaniques (à roues de comptage ou à aiguilles par exemple) ou encore des détecteurs angulaires.

En outre, au lieu d'être de type numérique, la régulation du flux ionique J ou de l'impédance Z peut être de type analogique et utiliser pour ce faire des boucles d'asservissement à actions proportionnelle, intégrale et dérivée.

**Revendications**

1. Procédé de détermination de l'impédance d'une décharge dans un réacteur (2) à plasma alimenté par un générateur de haute fréquence (4) par l'intermédiaire d'une boîte d'accord (6) comportant des capacités variables (10, 12), caractérisé en ce qu'il comprend les étapes suivantes :
   - on établit préalablement et expérimentalement une correspondance entre, d'une part, des états respectifs des capacités variables, qui sont déterminés réacteur éteint, hors fonctionnement, pour avoir une puissance réfléchie nulle en direction du générateur et, d'autre part, l'impédance de la décharge mesurée pour lesdits états des capacités, réacteur éteint,
   - on détermine l'impédance de la décharge du réacteur allumé en fonctionnement, à partir des états pris par les capacités variables pour avoir une puissance réfléchie nulle, et de la correspondance préalablement établie.

2. Procédé selon la revendication 1, caractérisé en ce que l'on détermine en outre le flux ionique relatif à la décharge dans le réacteur (2) à partir de la tension haute fréquence appliquée entre les bornes du réacteur, des états pris par les capacités variables (10, 12) et d'une correspondance préalablement et expérimentalement établie entre, d'une part, des états respectifs des capacités variables, qui sont déterminés réacteur éteint, hors fonctionnement, pour avoir une puissance réfléchie nulle en direction du générateur et, d'autre part, l'impédance de la décharge mesurée pour lesdits états des capacités, réacteur éteint.

3. Dispositif de détermination de l'impédance d'une décharge dans un réacteur (2) à plasma alimenté par un générateur de haute fréquence (4) par l'intermédiaire d'une boîte d'accord (6) comportant des capacités variables (10, 12), caractérisé en ce qu'il comprend :
   - des capteurs (42, 44) aptes à fournir des signaux représentatifs des états respectifs de ces capacités variables, et
   - des moyens électroniques de traitement (54) prévus pour déterminer l'impédance de la décharge du réacteur allumé en fonctionnement à partir des signaux représentatifs des états pris par les capacités variables pour avoir une puissance réfléchie nulle, d'une correspondance préalablement et expérimentalement établie entre, d'une part, des états respectifs des capacités variables, qui sont déterminés réacteur éteint, hors fonctionnement, pour avoir une puissance réfléchie nulle en direction du générateur et, d'autre part, l'impédance de la décharge mesurée pour lesdits états des capacités, réacteur éteint, cette correspondance étant mémorisée dans les moyens électroniques de traitement.

4. Dispositif selon la revendication 3, caractérisé en ce que les moyens électroniques de traitement (54) sont prévus pour déterminer le flux ionique relatif à la décharge dans le réacteur (2) à partir de la tension haute fréquence appliquée entre les bornes du réacteur, des signaux fournis par les capteurs (42, 44) et d'une correspondance préalablement et expérimentalement établie entre, d'une part, des états respectifs des capacités variables, qui sont déterminés réacteur éteint, hors fonctionnement, pour avoir une puissance réfléchie nulle en direction du générateur et, d'autre part, l'impédance de la décharge mesurée pour lesdits états des capacités, réacteur éteint, cette correspondance étant mémorisée dans les moyens électroniques de traitement.

5. Système de régulation de l'impédance de la décharge ou du flux ionique dans un réacteur (2) à plasma de haute fréquence alimenté par un générateur (58) de haute fréquence par l'intermédiaire d'une boîte d'accord (6) associée à des moyens d'accord automatique (8), la boîte d'accord comportant des capacités variables (10, 12) et étant prévue pour adapter l'impédance de sortie du générateur (58) à l'impédance d'entrée du réacteur (2), les moyens d'accord automatique (8) étant prévus pour ajuster les états des capacités variables de la boîte d'accord par l'intermédiaire de moyens (14, 16) de modification de ces états, de façon à annuler la puissance réfléchie vers le générateur, système comprenant un dispositif selon l'une quelconque des revendications 3 ou 4, les moyens électroniques de traitement (54) que comporte le dispositif sont en outre prévus pour commander la puissance du générateur de telle manière que l'impédance de la décharge ou le flux ionique qu'ils déterminent soit maintenu égal à une valeur de consigne.

6. Système selon la revendication 5, caractérisé en ce que les moyens de modification du dispositif sont des moteurs (14, 16) et en ce que les capteurs (42, 44) sont de type potentiométrique et sont respectivement montés sur les arbres des moteurs.

## Claims

1. Process for the determination of the impedance of a discharge in a plasma reactor (2) supplied by a high frequency generator (4) by means of a tuning box (6) having variable capacitors (10, 12), characterized in that it comprises the following stages:
   - beforehand and experimentally a correspondence is established between on the one hand respective states of the variable capacitors, which are determined with the reactor extinguished and not operating, so as to have a zero reflected power in the direction of the generator and on the other hand the impedance of the discharge measured for said states of the capacitors with the reactor extinguished,
   - determination takes place of the impedance of the discharge of the ignited reactor operating, on the basis of states assumed by the variable capacitors in order to have a zero reflected power and the previously established correspondence.

2. Process according to claim 1, characterized in that determination also takes place of the ionic flux relative to the discharge in the reactor (2) on the basis of the high frequency voltage applied between the terminals of the reactor, states assumed by the variable capacitors (10, 12) and a previously and experimentally established correspondence between on the one hand respective states of the variable capacitors, which are determined with the reactor extinguished and not operating in order to have a zero reflected power in the direction of the generator and on the other hand the impedance of the measured discharge for said states of the capacitors and with the reactor extinguished.

3. Apparatus for the determination of the impedance of a discharge in a plasma reactor (2) supplied by a high frequency generator (4) by means of a tuning box (6) having variable capacitors (10, 12), characterized in that it comprises:
   - sensors (42, 44) able to supply signals representative of the respective states of said variable capacitors and
   - electronic processing means (54) for determining the impedance of the discharge of the ignited, operating reactor on the basis of representative signals of states assumed by the variable capacitors in order to have a zero reflected power,
   a previously and experimentally established correspondence between on the one hand the respective states of the variable capacitors, which are determined with the reactor extinguished and not operating, in order to have a zero reflected power in the direction of the generator and on the other hand the impedance of the measured discharge for said states of the capacitors with the reactor extinguished, said correspondence being stored in the electronic processing means.

4. Apparatus according to claim 3, characterized in that the electronic processing means (54) serve to determine the ionic flux relative to the discharge in the reactor (2) on the basis of the high frequency voltage applied between the reactor terminals, signals supplied by the sensors (42, 44) and a previously and experimentally established correspondence between on the one hand respective states of the variable capacitors, which are determined with the reactor extinguished and not operating, so as to have a zero reflected power in the direction of the generator and on the other hand the impedance of the measured discharge for said states of the capacitors with the reactor extinguished, said correspondence being stored in the electronic processing means.

5. System for regulating the impedance of the discharge or ionic flux in a high frequency plasma reactor (2) supplied by a high frequency generator (58) by means of a tuning box (6) associated with automatic tuning means (8), the tuning box having variable capacitors (10, 12) and is used for matching the output impedance of the generator (58) with the input impedance of the reactor (2), the automatic tuning means (8) serving to adjust the states of the variable capacitors of the tuning box by means of means (14, 16) for modifying these states, so as to cancel out the reflected power towards the capacitor, said system comprising an apparatus according to either of the claims 3 or 4, the electronic processing means (54) of the apparatus also controlling the power of the generator in such a way that the impedance of the discharge or the ionic flux which they determine is maintained equal to a desired value.

6. System according to claim 5, characterized in that the means for modifying the apparatus are motors (14, 16) and in that the sensors (42, 44) are of the potentiometric type and are respectively mounted on the shafts of the motors.

**Patentansprüche**

1. Verfahren zum Bestimmen der Entladungsimpedanz in einem Plasmareaktor (2), der von einem Hochfrequenzgenerator (4) über eine Anpassungseinheit (6) gespeist wird, die veränderbare Kapazitäten (10, 12) umfaßt, dadurch gekennzeichnet, daß es die folgenden Schritte umfaßt:
   - man stellt vorausgehend und mittels Versuches eine Übereinstimmung zwischen einerseits den jeweiligen Zuständen der veränderbaren Kapazitäten, die bei abgeschaltetem, sich außer Betrieb befindendem Reaktor, um eine reflektierte Leistung von null in Richtung zu dem Generator zu haben, bestimmt werden, und andererseits der Entladungsimpedanz fest, die bei abgeschaltetem Reaktor für die genannten Zustände der Kapazitäten gemessen wird,

- man bestimmt die Entladungsimpedanz des Reaktors, der zum Betrieb eingeschaltet ist, auf der Grundlage der Zustände, die von den veränderbaren Kapazitäten eingenommen werden, um eine reflektierte Leistung von null zu haben, und aus der vorausgehend festgestellten Übereinstimmung.

2.  Verfahren nach Anspruch 1, dadurch gekennzeichnet, daß man ferner den Ionenfluß in bezug auf die Entladung in dem Reaktor (2) auf der Grundlage der zwischen die Klemmen des Reaktors angelegten Hochfrequenzspannung, der von den veränderbaren Kapazitäten (10, 12) eingenommenen Zustände und einer vorausgehend und durch Versuch festgestellte Übereinstimmung bestimmt, die einerseits zwischen den jeweiligen Zuständen der veränderbaren Kapazitäten, die bei abgeschalteten, sich außer Betrieb befindendem Reaktor bestimmt werden, um eine reflektierte Leistung von null in Richtung des Generators zu haben, und andererseits der Entladungsimpedanz hergestellt wird, die bei den für die genannten Zuständen der Kapazitäten bei abgeschaltetem Reaktor gemessen wird.

3.  Einrichtung zum Bestimmen der Entladungsimpedanz bei einem Plasmareaktor (2) der über eine Anpassungseinheit (6) von einem Hochfrequenzgenerator (4) gespeist wird, die veränderbare Kapazitäten (10, 12) umfaßt, dadurch gekennzeichnet, daß sie umfaßt:
    - Meßfühler (42, 44), die Signale liefern können, die für die jeweiligen Zustände dieser veränderbaren Kapazitäten repräsentativ sind, und
    - elektronische Verarbeitungseinrichtungen (54), die vorgesehen sind, um die Entladungsimpedanz des betriebsmäßig eingeschalteten Reaktors auf der Grundlage der Signale, die für die von den veränderbaren Kapazitäten eingenommenen Zustände, um eine reflektierte Leistung von null zu haben, repräsentativ sind, einer vorausgehend und durch Versuch hergestellten Übereinstimmung zwischen einerseits den entsprechenden Zuständen der veränderbaren Kapazitäten, die bei abgeschalteten, sich außer Betrieb befindendem Reaktor bestimmt worden sind, um eine reflektierte Leistung von null in Richtung zu dem Generator zu haben, und andererseits der Entladungsimpedanz, die für die genannten Zustände der Kapazitäten bei abgeschaltetem Reaktor gemessen worden sind, wobei diese Übereinstimmung in den elektronischen Verarbeitungseinrichtungen gespeichert wird.

4.  Einrichtung gemäß Anspruch 3, dadurch gekennzeichnet, daß die elektronischen Verarbeitungseinrichtungen (54) vorgesehen sind, um den Ionenfluß in bezug auf die Entladung in dem Reaktor (2) auf der Grundlage der zwischen die Klemmen des Reaktors angelegten Hochfrequenzspannung, der von den Meßfühlern (42, 44) gelieferten Signale und einer vorausgehend und durch Versuch hergestellten Übereinstimmung zwischen einerseits, den entsprechenden Zuständen der veränderbaren Kapazitäten, die bei abgeschaltetem, sich außer Betrieb befindendem Reaktor bestimmt worden sind, um eine reflektierte Leistung von null in Richtung zu dem Generator zu haben, und andererseits der Entladungsimpedanz, die für die genannten Zustände der Kapazitäten bei abgeschaltetem Reaktor gemessen worden sind, zu bestimmen, wobei diese Übereinstimmung in den elektronischen Verarbeitungseinrichtungen gespeichert wird.

5.  System zum Regeln der Entladungsimpedanz oder des Ionenflusses in einem Hochfrequenz-Plasmareaktor (2), der von einem Hochfrequenzgenerator (58) über eine Anpassungseinheit (6) gespeist wird, die mit automatischen Anpassungseinrichtungen (8) verbunden ist, wobei die Anpassungseinheit veränderbare Kapazitäten (10, 12) umfaßt und vorgesehen ist, um die Ausgangsimpedanz des Generators (58) in die Eingangsimpedanz des Reaktors (2) anzupassen, wobei automatische Anpassungseinrichtungen (8) vorgesehen sind, um die Zustände der veränderbaren Kapazitäten der Anpassungseinheit über Einrichtungen (14, 16) zum Verändern dieser Zustände derart einzustellen, daß die zu dem Generator reflektierte Leistung aufgehoben wird, wobei das System eine Einrichtung gemäß irgendeinem der Ansprüche 3 oder 4 umfaßt, die elektronischen Verarbeitungseinrichtungen (54), die die Einrichtung umfaßt, ferner vorgesehen sind, um die Leistung des Generators derart zu steuern, daß die Entladungsimpedanz oder der Ionenfluß, den sie bestimmen, gleich einem Sollwert aufrechterhalten werden.

6.  System gemäß Anspruch 5, dadurch gekennzeichnet, daß die Veränderungseinrichtungen der Einrichtung Motoren (14, 16) sind, und daß die Meßfühler (42, 44) vom Potentiometertyp sind und jeweils an den Wellen der Motoren angebracht sind.

FIG. 1

FIG. 2

FIG. 3

FIG. 4

FIG. 5

FIG. 6

FIG. 7